(19) Europäisches Patentamt
European Patent Office
Office européen des brevets

(11) **EP 2 315 337 B1**

(12) **EUROPÄISCHE PATENTSCHRIFT**

(45) Veröffentlichungstag und Bekanntmachung des Hinweises auf die Patenterteilung:
**15.03.2017 Patentblatt 2017/11**

(51) Int Cl.:
**H03K 17/96** (2006.01)  **H02J 9/00** (2006.01)

(21) Anmeldenummer: **10187836.1**

(22) Anmeldetag: **18.10.2010**

(54) **Haushaltsgerät und Verfahren zum Betreiben eines Haushaltsgeräts**

Domestic appliance and method for operating same

Appareil ménager et procédé de fonctionnement d'un appareil ménager

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **23.10.2009 DE 102009045968**

(43) Veröffentlichungstag der Anmeldung:
**27.04.2011 Patentblatt 2011/17**

(73) Patentinhaber: **BSH Hausgeräte GmbH
81739 München (DE)**

(72) Erfinder:
• **Bosen, Peter
93161, Sinzing (DE)**
• **Piermeier, Simon
94379, Sankt Englmar (DE)**

(56) Entgegenhaltungen:
**EP-A1- 0 746 100       EP-A2- 1 675 265
DE-U1-202006 019 991   GB-A- 2 341 500
US-A- 5 194 951**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein Haushaltsgerät sowie ein Verfahren zum Betreiben eines Haushaltsgeräts.

Es ist bekannt, dass elektrische Geräte zwischen einem Aktivzustand und einem Wartezustand (auch unter der Bezeichnung "Stand-by" bekannt) überführt werden können. Während im Aktivzustand alle elektrischen Verbraucher eines Geräts eingeschaltet sind, d.h. elektrische Energie zum Betreiben dieser Verbraucher bereitgestellt ist, soll die Energie im Wartezustand gespart werden. In der Regel wird angestrebt, den Energieverbrauch eines Geräts im Wartezustand auf unterhalb 1 Watt zu reduzieren.

Aus dem Dokument GB 2 341 500 A ist eine elektrische Schaltungsanordnung für ein elektrisches Gerät - etwa einen Fernseher bekannt -, welche zum Versorgen des elektrischen Gerätes mit elektrischer Energie dient. Das elektrische Gerät kann zwischen einem Standby-Zustand und einem Aktiv-Zustand hin- und hergeschaltet werden, und zwar mittels einer Fernbedienung.

Das Dokument DE 20 2006 019 991 U1 beschreibt eine Schaltungsanordnung für einen kapazitiven Nährungsschalter, welche zur Bestimmung des Betätigungszustands des Näherungsschalters ausgebildet ist. Mit dem kapazitiven Näherungsschalter ist ein Sammelkondensator elektrisch gekoppelt, dessen elektrische Spannung durch eine Auswerteeinrichtung abgegriffen und ausgewertet wird. Anhand von Spannungsimpulsen wird durch die Auswerteeinrichtung erkannt, ob der Näherungsschalter betätigt wird oder nicht.

Eine Schaltungsanordnung zum Betreiben eines kapazitiven Berührungsschalters ist außerdem aus der Druckschrift EP 1 675 265 A2 als bekannt zu entnehmen.

Das Dokument EP 0 746 100 A1 beschreibt ebenfalls eine Schaltungsanordnung, welche zum Betrieb eines kapazitiven, induktiven oder resistiven Elementes dient, welches als Sensor zum Erfassen des Überschreitens oder Unterschreitens eines vorbestimmten Schwellwertes ausgebildet ist.

Ein Fernsehempfänger ist aus dem Dokument US 5 194 951 A bekannt.

Es ist Aufgabe der Erfindung, eine Lösung aufzuzeigen, wie elektrische Energie in einem Haushaltsgerät gespart werden kann.

Diese Aufgabe wird erfindungsgemäß durch ein Haushaltsgerät mit den Merkmalen gemäß Patentanspruch 1 wie auch durch ein Verfahren mit den Merkmalen gemäß Patentanspruch 13 gelöst. Vorteilhafte Ausführungen der Erfindung sind Gegenstand der abhängigen Ansprüche.

Ein erfindungsgemäßes Haushaltsgerät umfasst eine Schaltungsanordnung, die einen Schaltungseingang mit einem ersten und einem zweiten Eingangsanschluss zum Anlegen einer Versorgungswechselspannung aufweist. Ein Netzteil ist über einen elektrischen Schalter mit dem Schaltungseingang koppelbar, welches zum Bereitstellen einer Betriebsspannung ausgebildet ist. Das Haushaltsgerät wird mittels einer Steuereinrichtung gesteuert, welche mit der Betriebsspannung versorgbar ist. Die Steuereinrichtung ist dazu ausgebildet, das Haushaltsgerät von einem Aktivzustand in einen Wartezustand durch Öffnen des elektrischen Schalters zu überführen. Ferner ist eine mit dem Schaltungseingang kapazitiv gekoppelte Versorgungseinheit vorgesehen, die zum Bereitstellen einer Versorgungskleinspannung ausgebildet ist. Mit dieser Versorgungskleinspannung ist eine Auswerteeinheit versorgbar, welche dazu ausgebildet ist, abhängig von einer Auswertung eines Zustandsänderungssignals den elektrischen Schalter zu schließen und hierdurch das Haushaltsgerät von dem Wartezustand in den Aktivzustand zu überführen.

Es sind erfahrungsgemäß die Steuereinrichtung - welche einen Mikroprozessor umfassen kann - sowie weitere mit dem Netzteil gekoppelte elektrische Verbraucher, die in einem Haushaltsgerät am meisten Energie verbrauchen. Erfindungsgemäß werden die Steuereinrichtung und gegebenenfalls auch andere mit dem Netzteil gekoppelte Verbraucher im Wartezustand ausgeschaltet, indem das Netzteil von der Schaltungsanordnung entkoppelt wird. Im Wartezustand, welcher demnach gegenüber dem Aktivzustand einen energieverbrauchsreduzierten Zustand darstellt, wird somit lediglich die Versorgungswechselspannung kapazitiv ausgekoppelt und in Form der Versorgungskleinspannung in der Versorgungseinheit gespeichert. Also wird der erfindungsgemäße Effekt einerseits durch eine Versorgungseinheit erzielt, welche über eine verlustarme kapazitive Kopplung am Schaltungseingang elektrische Energie abgreift und eine Versorgungskleinspannung bereitstellt. Andererseits ermöglicht eine Auswerteeinheit, die im Wartezustand mit der Versorgungskleinspannung versorgt wird, die Auswertung eines Zustandsänderungssignals und abhängig von dieser Auswertung das Schließen des elektrischen Schalters und hierdurch das Überführen des Haushaltsgeräts in den Aktivzustand. Es ist demnach lediglich die Auswerteeinheit, die elektrische Energie im Wartezustand verbrauchen kann, sie wird nämlich mit der Versorgungskleinspannung versorgt.

Die Versorgungseinheit stellt vorzugsweise ein kleines transformatorloses Netzteil dar, welches einen Gleichrichter sowie einen Pufferkondensator aufweist, in welchem die Versorgungskleinspannung gespeichert wird. Dann liegt die Versorgungskleinspannung am Pufferkondensator an und kann von der Auswerteeinheit abgegriffen werden. Die Versorgungseinheit ist bevorzugt über zwei in das Haushaltsgerät zusätzlich eingesetzte, eigenständige Y-Kondensatoren mit dem Schaltungseingang kapazitiv gekoppelt. Dann liegt eine galvanische Trennung zwischen dem Schaltungseingang und der Versorgungseinheit vor, und es wird den Anforderungen an Sicherheit Genüge getan. Die Y-Kondensatoren werden also durch die Versorgungseinheit als kapazitive Vorwiderstände genutzt.

Eine diesbezügliche Schaltungsanordnung ist für andere Zwecke in dem Dokument EP 0 689 351 A2 erläutert. Die Erfindung beruht somit auf der Erkenntnis, dass eine solche Schaltungsanordnung zum Überführen eines Haushaltsgeräts zwischen einem Wartezustand und einem Aktivzustand besonders vorteilhaft verwendet werden kann. Unter einem Haushaltsgerät wird vorliegend ein Gerät verstanden, das zur Haushaltsführung eingesetzt wird. Das kann ein Haushaltsgroßgerät sein, wie beispielsweise eine Waschmaschine, ein Wäschetrockner, eine Geschirrspülmaschine, ein Gargerät, eine Dunstabzugshaube, ein Kältegerät, eine Kühlgefrierkombination oder ein Klimagerät. Das kann aber auch ein Haushaltskleingerät sein, wie beispielsweise ein Kaffeevollautomat oder eine Küchenmaschine.

Die Auswerteeinheit analysiert das Zustandsänderungssignal und überführt das Haushaltsgerät in den Aktivzustand abhängig von dem Ergebnis dieser Auswertung. Unterschiedliche Ausführungsformen bezüglich der Auswertung können vorgesehen sein. Ganz allgemein kann das Zustandsänderungssignal mittels einer Bedieneinrichtung des Haushaltsgeräts bereitgestellt werden. Es ist vorgesehen, dass ein kapazitiver Berührungs- oder Annäherungssensor mit der Auswerteeinheit gekoppelt ist, der das Zustandsänderungssignal an die Auswerteeinheit ausgibt. Das Zustandsänderungssignal ändert sich dann - sei es in der Amplitude oder in der Frequenz je nach Ausgestaltung des Berührungs- oder Annäherungssensors - bei einem Berühren durch eine Bedienperson oder bei einer Annäherung der Bedienperson an das Haushaltsgerät.

Der Berührungs- oder Annäherungssensor kann einen Transistor, insbesondere einen PNP-Bipolartransistor, umfassen, dessen Kollektor mit einem Ausgang des Berührungs- oder Annäherungssensors und hierdurch mit der Auswerteeinheit gekoppelt ist. Der Berührungs- oder Annäherungssensor kann außerdem einen Kondensator umfassen, dessen Kapazitätswert durch Annäherung einer Bedienperson veränderbar ist und welcher mit dem Steueranschluss des Transistors gekoppelt ist. Nähert sich eine Bedienperson dem Kondensator, so ändert sich seine Kapazität, was die Auswerteeinheit anhand des Zustandsänderungssignals erkennen kann. Der Steueranschluss und der Emitter des Transistors können mit dem Eingang des Berührungs- oder Annäherungssensors und hierdurch mit einem Ausgang der Auswerteeinheit gekoppelt sein, nämlich beispielsweise über jeweils einen ohmschen Widerstand. Dann kann die Auswerteeinheit den Berührungs- oder Annäherungssensor mit einer Gleichspannung oder mit Spannungsimpulsen beaufschlagen, um anhand des vom Berührungs- oder Annäherungssensor ausgegebenen Zustandsänderungssignals zu erkennen, ob eine Bedienperson den Berührungs- oder Annäherungssensor betätigt oder nicht. Ein solcher Aufbau des Annäherungssensors sorgt dafür, dass die Steuereinrichtung die Betätigung des Annäherungssensors durch eine Bedienperson besonders einfach erkennen kann, nämlich anhand der Amplitude des Zustandsänderungssignals. Ein Annäherungssensor, dessen Betätigung anhand der Amplitude des Ausgangssignals erkannt werden kann, ist bereits aus dem Dokument DE 10 2005 041 113 A1 bekannt. Dort wird an den Annäherungssensor ein Taktsignal ausgegeben, dessen Frequenz in einem Wertebereich von 10 bis 100 kHz liegt. Am Ausgang des Annäherungssensors steht dann ein Gleichspannungssignal für die Auswertung zur Verfügung. Eine besondere Herausforderung besteht darin, diese Lösung gemäß Druckschrift

DE 10 2005 041 113 A1 dahingehend zu verbessern, dass weniger Energie bei der Auswertung des Ausgangssignals verbraucht wird.

Es ist deshalb vorgesehen, dass die Auswerteeinheit in vorbestimmten Zeitabständen jeweils ein Beaufschlagen des Berührungs- oder Annäherungssensors mit einer vorbestimmten Anzahl von Spannungsimpulsen - zum Beispiel mit 2 oder 3 Spannungsimpulsen - aus der Versorgungskleinspannung veranlasst, um anhand des Zustandsänderungssignals des Berührungs- oder Annäherungssensors zu erkennen, ob eine Bedienperson den Berührungs- oder Annäherungssensor betätigt oder nicht. Zum Beispiel kann die Auswerteeinheit alle 10 ms bis 100 ms den Berührungs- oder Annäherungssensor jeweils mit zumindest zwei Spannungsimpulsen beaufschlagen. Die Zeitdauer eines einzelnen Spannungsimpulses liegt bevorzugt in einem Wertebereich von 10 $\mu$s bis 50 $\mu$s; der zeitliche Abstand zwischen zwei nacheinander folgenden Spannungsimpulsen liegt bevorzugt in einem Wertebereich von 60 $\mu$s bis 100 $\mu$s. Also kann der Berührungs- oder Annäherungssensor im Gegensatz zum Gegenstand gemäß Druckschrift DE 10 2005 041 113 A1 - dort wird der Annäherungssensor mit einem Taktsignal mit einer Frequenz von 10 kHz bis 100 kHz beaufschlagt - mit jeweils wenigen Spannungsimpulsen in vorbestimmten Zeitabständen, zum Beispiel alle 100 ms, beaufschlagt werden. Werden zum Beispiel nur drei

Spannungsimpulse innerhalb einer Zeit von 100 ms an den Berührungs- oder Annäherungssensor abgegeben, so ist die Leistungsaufnahme des Berührungs- oder Annäherungssensors im Wartezustand des Haushaltsgeräts entsprechend sehr gering. Auf diesem Wege gelingt es, die im Wartezustand vom Haushaltsgerät aufgenommene Energie auf ein Minimum zu reduzieren.

Werden an den Berührungs- oder Annäherungssensor nur wenige Impulse innerhalb eines vorbestimmten Zeitintervalls abgegeben, so beinhaltet das Zustandsänderungssignal - also das Ausgangssignal des Berührungs- oder Annäherungssensors - ebenfalls Spannungsimpulse, deren Höhe davon abhängt, ob eine Bedienperson den Berührungs- oder Annäherungssensor betätigt oder nicht. Es gilt dabei die Beziehung, dass die Amplitude der Spannungsimpulse des Zustandsänderungssignals dann höher ist, wenn eine Bedienperson den Berührungs- oder Annäherungssensor betätigt. Es kann somit anhand der Auswertung der Amplitude der Spannungsimpulse des Zustandsänderungssignals erkannt werden, ob eine Bedienperson den Berührungs- oder Annäherungssensor betätigt oder nicht beziehungsweise ob das Haushaltsgerät zwischen dem Wartezustand und dem Aktivzustand überführt werden soll oder nicht.

Die Auswertung des Zustandsänderungssignals kann zum Beispiel so aussehen, dass die Auswerteeinheit die Amplitude des Zustandsänderungssignals mit einem Referenzsignal vergleicht und abhängig von dem Vergleich erkennt, ob eine Bedienperson den Berührungs- oder Annäherungssensor betätigt oder nicht. Da die Amplitude des Referenzsignals in der Auswerteeinheit bekannt ist, kann auch die absolute Amplitude des Zustandsänderungssignals durch die Auswerteeinheit ermittelt beziehungsweise gemessen werden.

Die Auswerteeinheit kann überprüfen, ob die Amplitude eines Spannungsimpulses des Zustandsänderungssignals des Berührungs- oder Annäherungssensors innerhalb eines bestimmten Wertebereichs liegt. Liegt diese Amplitude innerhalb des bestimmten Wertebereichs, so kann die Auswerteeinheit bestätigen, dass eine Bedienperson den Berührungs- oder Annäherungssensor betätigt. Liegt die Amplitude des Spannungsimpulses unterhalb des Wertebereichs, so liegt keine Betätigung des Annäherungssensors vor. Überschreitet hingegen die Amplitude des Spannungsimpulses den bestimmten Wertebereich, so liegt ein Fehlerfall vor, und die Auswerteeinheit berücksichtigt in einem solchen Fall den Spannungsimpuls nicht. Das Haushaltsgerät wird also nur dann von dem Wartezustand in den Aktivzustand überführt, wenn die Amplitude des Spannungsimpulses des Zustandsänderungssignals innerhalb des bestimmten Wertebereichs liegt.

Die Amplitude der Spannungsimpulse des vom Berührungs- oder Annäherungssensor ausgegebenen Zustandsänderungssignals ist jedoch nicht nur davon abhängig, ob eine Bedienperson den Berührungs- oder Annäherungssensor betätigt oder nicht. Diese Amplitude wird außerdem durch weitere Einflussgrößen beeinflusst. Zum Beispiel wird die Amplitude der vom Berührungs- oder Annäherungssensor ausgegebenen Spannungsimpulse durch die Temperatur und andere umgebungsbedingte Störgrößen beeinflusst. Um all diese Beeinflussungen der Amplitude des Zustandsänderungssignals des Berührungs- oder Annäherungssensors bei der Auswertung des Zustandsänderungssignals zu berücksichtigen, ist in einer Ausführungsform vorgesehen, dass die Auswerteeinheit den Wertebereich an die Amplitude des Zustandsänderungssignals anpasst. Und zwar kann die Auswerteeinheit nach Empfangen eines Spannungsimpulses des Zustandsänderungssignals den Wertebereich für die Auswertung nachfolgender Spannungsimpulse abhängig von der Amplitude des empfangenen Spannungsimpulses erneut bestimmen. Dann ist gewährleistet, dass etwaige Störgrößen die Auswertung des Zustandsänderungssignals nicht verfälschen können.

Wird die Versorgungswechselspannung an den Schaltungseingang zum ersten Mal angelegt beziehungsweise wird die Schaltungsanordnung mit einem elektrischen Versorgungsnetz gekoppelt, so wird der Wertebereich durch die Auswerteeinheit erstmals bestimmt. Dies kann derart erfolgen, dass die Auswerteeinheit den Berührungs- oder Annäherungssensor mit einer Abfolge von Spannungsimpulsen beaufschlagt und die Amplitude der Spannungsimpulse des Zustandsänderungssignals des Berührungs- oder Annäherungssensors misst. Der untere Grenzwert des Wertbereichs wird zunächst so bestimmt, dass er etwas größer als die Amplitude der empfangenen Spannungsimpulse ist. Der obere Grenzwert des Wertebereichs kann bezüglich des unteren Grenzwerts in der Auswerteeinheit vordefiniert werden. Wird also der untere Grenzwert des Wertebereichs bestimmt, so ergibt sich daraus automatisch der obere Grenzwert, so dass der gesamte Wertebereich durch Bestimmen lediglich des unteren Grenzwertes bestimmt werden kann.

Ist der Wertebereich erstmals bestimmt - nämlich nach Inbetriebnahme der Schaltungsanordnung - so kann die Auswerteeinheit mit der Überwachung des Berührungs- oder Annäherungssensors beginnen, indem sie zum Beispiel - wie oben ausgeführt - den Berührungs- oder Annäherungssensor in vorbestimmten Zeitabständen jeweils mit einer vorbestimmten Anzahl von Spannungsimpulsen aus der Versorgungskleinspannung beaufschlagt. Zu jedem Spannungsimpuls, mit welchem der Berührungs- oder Annäherungssensor beaufschlagt wird, ergibt sich ein Spannungsimpuls in dem Zustandsänderungssignal. Die Auswerteeinheit überprüft, ob die Amplitude des Spannungsimpulses des Zustandsänderungssignals innerhalb des bestimmten Wertebereichs liegt oder nicht. Wird dies durch die Auswerteeinheit bestätigt, so wird das Haushaltsgerät in den Aktivzustand überführt. Ist die Amplitude des empfangenen Spannungsimpulses geringer als der bestimmte Wertebereich, so liegt keine Betätigung des Berührungs- oder Annäherungssensors vor. In jedem Fall bestimmt die Steuereinrichtung den Wertebereich erneut, nämlich abhängig von der Amplitude des empfangenen Spannungsimpulses des Zustandsänderungssignals. Eine solche Anpassung des Wertebereichs kann zum Beispiel so aussehen, dass eine Differenz aus dem momentanen unteren Grenzwert des Wertebereichs und der Amplitude des aktuell empfangenen Spannungsimpulses mit einem Faktor kleiner eins multipliziert wird und das Ergebnis dieser Multiplizierung dem aktuellen unteren Grenzwert des Wertebereichs aufaddiert wird. Dann ergibt sich ein neuer unterer Grenzwert des Wertebereichs, und der Wertebereich wird erneut bestimmt, nämlich für die Auswertung nachfolgender Spannungsimpulse.

Bei dieser Ausführungsform, in welcher ein Berührungs- oder Annäherungssensor eingesetzt wird, kann dieser Sensor auch so konzipiert werden, dass das Zustandsänderungssignal eine Wechselspannung ist, deren Frequenz bei einem Berühren durch eine Bedienperson oder einer Annäherung der Bedienperson an das Haushaltsgerät verändert wird. Diese Änderung der Frequenz kann dann unmittelbar durch die Auswerteeinheit erkannt werden, und die Auswerteeinheit kann abhängig von dieser Änderung das Haushaltsgerät in den Aktivzustand überführen. Der Berührungs-oder Annäherungssensor kann hier zum Beispiel eine Resonanzschaltung umfassen, die das Zustandsänderungssignal mit einer bestimmten Frequenz bereitstellt. Diese Frequenz kann dann durch Veränderung der Kapazität eines Kondensators der Resonanzschaltung durch eine Bedienperson verändert werden.

Der Berührungs- oder Annäherungssensor umfasst insbesondere eine Sensorelektrode, die mit der Auswerteeinheit gekoppelt ist. Nähert sich eine Bedienperson der Sensorelektrode oder berührt die Bedienperson selbige, so ändert sich die Kapazität eines diese Sensorelektrode aufweisenden Kondensators. Dies stellt eine besonders komfortable Bedienart des Haushaltsgeräts dar.

Der Einsatz eines Berührungs- oder Annäherungssensors ermöglicht das Aktivieren des Haushaltsgeräts im Hintergrund bei einer Annäherung einer Bedienperson an das Haushaltsgerät. Dies kann zum Beispiel auf eine solche Art und Weise veranlasst werden: Eine Bedienperson nähert sich dem Haushaltsgerät. Dann ändert sich die Kapazität eines die Sensorelektrode aufweisenden Kondensators. Durch die Änderung der Kapazität wird die Amplitude oder die Frequenz des Zustandsänderungssignals - wie oben dargestellt - verändert, und die Auswerteeinheit wertet diese Änderung aus. Abhängig vom Ergebnis dieser Auswertung bewirkt die Auswerteeinheit das Schließen des elektrischen Schalters und hierdurch das Überführen des Haushaltsgeräts in den Aktivzustand. Diese Aktivierung des Haushaltsgeräts erfolgt im Hintergrund, d.h. unbemerkbar für die Bedienperson. Nach dem Überführen in den Aktivzustand kann eine Bedieneinrichtung zum Bedienen des Haushaltsgeräts und/oder eine Anzeigeeinrichtung aktiviert werden. Das Haushaltsgerät steht nun zum Betrieb bereit. Ein Vorteil dieser Ausführungsform besteht darin, dass die Bedienperson das Haushaltsgerät selbst nicht aktivieren muss, das Haushaltsgerät aktiviert sich "selbst", ohne dass es einer Handlung vonseiten der Bedienperson bedarf.

Gemäß einer Ausführungsform kann das Zustandsänderungssignal der Auswerteeinheit beispielsweise von einer aktiven Sensoreinrichtung übermittelt werden. Dies kann zum Beispiel so erfolgen, dass die aktive Sensoreinrichtung eine Bedienperson, die neben dem Haushaltsgerät steht, erkennt und unmittelbar oder nach Vornehmen einer Eingabe durch die Bedienperson das Zustandsänderungssignal an die Auswerteeinheit übermittelt. Dann empfängt die Auswerteeinheit das Zustandsänderungssignal und überführt das Haushaltsgerät in den Aktivzustand. Eine solche aktive Sensoreinrichtung kann zum Beispiel einen Bewegungssensor, einen Ultraschallsensor, einen optischen Sensor oder auch einen Mikrowellensensor umfassen.

Vorzugsweise ist die Steuereinrichtung dazu ausgelegt, den elektrischen Schalter nach Erfülltsein eines vorbestimmten Kriteriums zu öffnen und hierdurch das Haushaltsgerät vom Aktivzustand in den Wartezustand zu überführen. Also kann die Steuereinrichtung den elektrischen Schalter selbst öffnen und so das Haushaltsgerät in den Wartezustand überführen. Dann wird auch die Steuereinrichtung selbst ausgeschaltet, und es wird keine elektrische Energie über das Netzteil verbraucht. Das vorbestimmte Kriterium wird also vorzugsweise so gewählt, dass das Haushaltsgerät nicht unnötigerweise im Aktivzustand verbleibt. Das Kriterium kann zum Beispiel beinhalten, dass die Steuereinrichtung über ein vorbestimmtes Zeitintervall keine Eingabesignale von einer Bedieneinrichtung erhält. Erfolgt keine Handlung durch eine Bedienperson während des vorbestimmten Zeitintervalls, so wird das Haushaltsgerät in den Wartezustand überführt. Es kann auch vorgesehen sein, dass die Steuereinrichtung das vorbestimmte Zeitintervall gar nicht abwarten muss. Gegebenenfalls kann das Haushaltsgerät auch durch die Bedienperson in den Wartezustand überführt werden. Dies kann zum Beispiel so aussehen, dass die Steuereinrichtung ein vorbestimmtes Eingabesignal von einer Bedieneinrichtung erhält und anschließend das Haushaltsgerät in den Wartezustand überführt. Ein solches Eingabesignal kann zum Beispiel durch Drücken eines Tasters oder durch eine andere Eingabe, die eine Bedienperson vornimmt, erzeugt werden.

Das Haushaltsgerät kann auch dann in den Wartezustand überführt werden, wenn ein Prozess des Haushaltsgeräts gerade beendet wurde. Dann umfasst das vorbestimmte Kriterium, dass die Steuereinrichtung einen Prozess des Haushaltsgeräts abgeschlossen hat. Zum Beispiel kann eine Waschmaschine unmittelbar nach Abschluss eines Waschprozesses in den Wartezustand überführt werden. Entsprechend kann ein Wäschetrockner unmittelbar nach Abschluss eines Trocknungsprozesses in den Wartezustand überführt werden. Eine solche Vorgehensweise sorgt für einen geringen Gesamtenergieverbrauch des Haushaltsgeräts.

Es hat sich als besonders vorteilhaft herausgestellt, wenn der elektrische Schalter ein bistabiler Schalter ist, nämlich insbesondere ein bistabiles Relais. Den Anforderungen diesbezüglich, dass ein bereits angefangener Prozess des Haushaltsgeräts nach einem Spannungsausfall beendet werden kann, kann somit Genüge getan werden. Zum Schalten eines solchen bistabilen Relais ist relativ wenig Energie erforderlich, solche Relais können im stromlosen Zustand zwei stabile Schaltzustände einnehmen. Eine geringe Versorgungskleinspannung ist somit ausreichend, um ein Schließen des Schalters durch die Auswerteeinheit zu veranlassen. Bei Anwendungen, bei denen keine bzw. nur eine kurzzeitige Spannungsausfallsüberbrückung gefordert ist, kann der elektrische Schalter alternativ als monostabiler Schalter ausgeführt werden, nämlich beispielsweise als monostabiles Relais oder ein Halbleiterschalter. Je nach Anwendung beziehungsweise je nach Anforderungen des Haushaltsgeräts kann also der elektrische Schalter unterschiedlich ausgebildet sein, nämlich als einfaches monostabiles Relais oder auch als bistabiles Relais. Darüber hinaus kann der elektrische Schalter im Neutralleiter oder im Phasenleiter der Schaltungsanordnung integriert sein; es können aber auch zwei elektrische Schalter - sowohl in dem Neutralleiter als auch in dem Phasenleiter vorgesehen sein. Hier kann zum Beispiel ein einfaches Relais mit zwei gleich wirkenden Kontakten, also eine so genannte allpolige Schaltung, eingesetzt werden. Gleichfalls kann ein bistabiler Schalter mit zwei gleich wirkenden Kontakten eingesetzt werden.

In einer Ausführungsform ist vorgesehen, dass nach Wiederkehr einer vorher ausgefallenen Versorgungswechselspannung die Auswerteeinheit unmittelbar den elektrischen Schalter schließt. Hier ist kein bistabiler Schalter erforderlich. Die Steuereinrichtung, die nach Schließen des Schalters unmittelbar mit elektrischer Energie versorgt wird, kann den geschlossenen Schaltzustand dann aufrechterhalten, wenn durch diesen Ausfall der Versorgungswechselspannung ein zuvor begonnenes Programm des Haushaltsgeräts unterbrochen wurde. Dann bleibt der Schalter geschlossen, und das Programm kann ordnungsgemäß abgeschlossen werden. War vor dem Ausfall der Versorgungswechselspannung kein Programm des Haushaltsgerät aktiv, so kann die Steuereinrichtung den Schalter öffnen und sich somit selbst ausschalten, so dass das Haushaltsgerät wieder in den Wartezustand übergeht. Eine Information über ein mögliches, durch den Ausfall der Versorgungswechselspannung unterbrochenes Programm kann zum Beispiel aus einem Speicher der Steuereinrichtung ausgelesen werden. Bei dieser Ausführungsform kommt also das Haushaltsgerät ohne einen bistabilen Schalter aus, was einen Kostenvorteil zur Folge hat.

Bei einem erfindungsgemäßen Verfahren zum Betreiben eines Haushaltsgeräts wird eine Versorgungswechselspannung an einem Schaltungseingang einer Schaltungsanordnung angelegt. Aus der Versorgungswechselspannung wird eine Versorgungskleinspannung durch eine mit dem Eingang kapazitiv gekoppelte Versorgungseinheit bereitgestellt. Mit der Versorgungskleinspannung wird eine Auswerteeinheit versorgt. Die Auswerteeinheit wertet ein Zustandsänderungssignal aus und schließt einen elektrischen Schalter abhängig von der Auswertung des Zustandsänderungssignals. Beim Schließen des elektrischen Schalters wird ein Netzteil mit dem Schaltungseingang gekoppelt, welches eine Betriebsspannung für eine Steuereinrichtung bereitstellt und hierdurch das Haushaltsgerät von einem Wartezustand in einen Aktivzustand überführt. Die Steuereinrichtung überprüft, ob ein vorbestimmtes Kriterium erfüllt ist oder nicht. Nach Erfülltsein des vorbestimmten Kriteriums öffnet die Steuereinrichtung den elektrischen Schalter und entkoppelt hierdurch das Netzteil von dem Schaltungseingang. Dann wird das Haushaltsgerät von dem Aktivzustand in den Wartezustand überführt.

Die mit Bezug auf das erfindungsgemäße Haushaltsgerät vorgestellten bevorzugten Ausführungsformen und insbesondere deren Vorteile gelten entsprechend für das erfindungsgemäße Verfahren.

Weitere Merkmale der Erfindung ergeben sich aus den Ansprüchen, den Figuren und der Figurenbeschreibung. Die vorstehend in der Beschreibung genannten Merkmale und Merkmalskombinationen sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen.

Die Erfindung wird nun anhand eines bevorzugten Ausführungsbeispiels sowie unter Bezugnahme auf die beigefügten Zeichnungen näher erläutert. Es zeigen:

Fig. 1          ein Blockschaltbild einer Schaltungsanordnung eines Haushaltsgeräts gemäß einer Ausführungsform der Erfindung;

Fig. 2          in schematischer Darstellung eine Auswerteeinheit und einen Berührungs- oder Annäherungssensor; und

Fig. 3a bis 3e    zeitliche Verläufe von an den Berührungs- oder Annäherungssensor abgegebenen Spannungsimpulsen sowie von dem Berührungs- oder Annäherungssensor ausgegebenen Spannungsimpulsen, wobei anhand der Verläufe ein Auswerteverfahren näher erläutert wird.

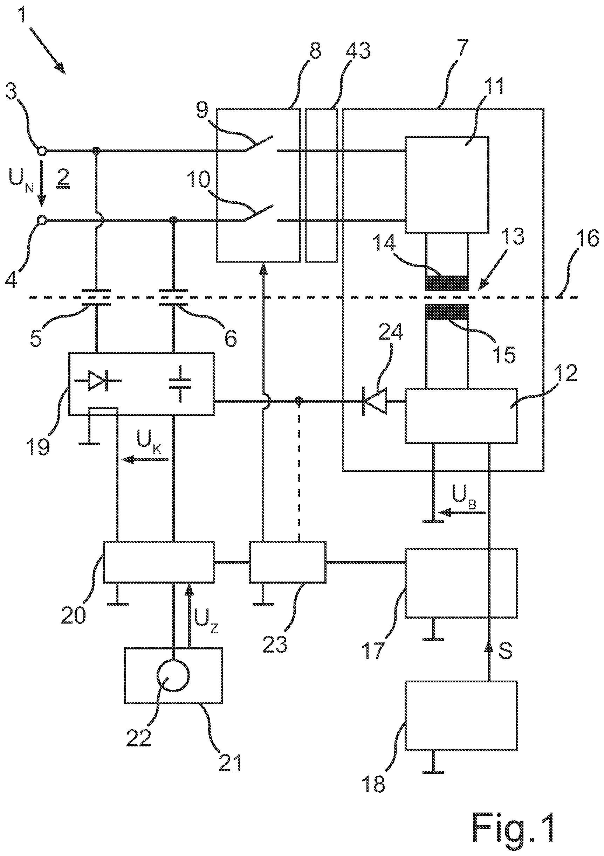

Eine in Fig. 1 anhand eines Blockschaltbilds dargestellte und im Ganzen mit 1 bezeichnete Schaltungsanordnung ist in einem Haushaltsgerät, hier beispielsweise in einer Waschmaschine, angeordnet und dient zum Betreiben des Haushaltsgeräts. Die Schaltungsanordnung 1 umfasst einen Schaltungseingang 2 mit einem ersten Eingangsanschluss 3 und einem zweiten Eingangsanschluss 4. Zwischen den Eingangsanschlüssen 3, 4 liegt eine Versorgungswechselspannung $U_N$. Mit dem Schaltungseingang 2 sind zwei Y-Kondensatoren 5, 6 gekoppelt. Die Y-Kondensatoren 5, 6 werden dazu verwendet, eine galvanische Entkopplung zum Schaltungseingang 2 zu erreichen. Die Y-Kondensatoren 5, 6 können in beiden Zweigen auch doppelt ausgeführt werden.

Mit dem Schaltungseingang 2 ist ein Netzteil 7 koppelbar, nämlich über eine Schalteinheit 8. Dabei ist das Netzteil 7 über einen ersten elektrischen Schalter 9 der Schalteinheit 8 mit dem ersten Eingangsanschluss 3 und über einen zweiten elektrischen Schalter 10 der Schalteinheit 8 mit dem zweiten Eingangsanschluss 4 koppelbar. Gegebenenfalls kann auf einen der Schalter 9, 10 verzichtet werden, zum Beispiel kann nur der zweite Schalter 10 oder nur der erste Schalter 9 verwendet werden. Wesentlich ist, dass das Netzteil 7 von dem Eingang 2 entkoppelt und mit diesem wieder gekoppelt werden kann.

Zwischen die Schalteinheit 8 und das Netzteil 7 ist ein Netzfilter 43 (EMV-Filter) geschaltet.

Das Netzteil 7 umfasst einen Primärstromkreis 11 sowie einen Sekundärstromkreis 12. Das Netzteil 7 umfasst außerdem einen Transformator 13, dessen erste Wicklung 14 dem Primärstromkreis 11 und dessen zweite Wicklung 15 dem Sekundärstromkreis 12 zugeordnet ist. Es liegt also eine galvanische Trennung zwischen dem Primärstromkreis 11 und dem Sekundärstromkreis 12 vor, nämlich durch den Transformator 13. Eine Potentialbarriere zwischen dem netzseitigen Primärstromkreis 11 und dem Sekundärstromkreis 12 ist in Fig. 1 anhand einer gestrichelten Linie 16 angedeutet.

Der Sekundärstromkreis 12 des Netzteils 7 kann - wie dies für Netzteile üblich ist - einen Gleichrichter sowie einen Kondensator aufweisen. Das Netzteil 7 stellt eine Betriebsspannung $U_B$ bereit, die eine Gleichspannung ist.

Mit dem Netzteil 7 ist eine Steuereinrichtung 17 gekoppelt, welche im Haushaltsgerät zum Steuern von dessen Funktionen vorhanden ist. Die Steuereinrichtung 17 kann durch einen Mikroprozessor gebildet sein oder einen solchen Mikroprozessor umfassen. Mit dem Netzteil 7 bzw. mit der Betriebsspannung $U_B$ können auch weitere elektrische Verbraucher gekoppelt sein, die in Fig. 1 nicht abgebildet sind, nämlich insbesondere Aktoren, Sensoren und dergleichen.

Eine Bedieneinrichtung 18 ist mit der Steuereinrichtung 17 gekoppelt. Durch die Bedieneinrichtung 18 werden an die Steuereinrichtung 17 Eingabesignale S übermittelt, zum Beispiel nach Vornehmen einer Eingabe durch eine Bedienperson. Die Bedieneinrichtung 18 kann zum Beispiel einen Programmdrehwähler zur Auswahl unterschiedlicher Funktionen der Waschmaschine sowie eine Anzeige zum Anzeigen der ausgewählten Funktionen umfassen.

Mit dem Schaltungseingang 2 ist eine Versorgungseinheit 19 kapazitiv gekoppelt, nämlich über die Y-Kondensatoren 5, 6. Die Versorgungseinheit 19 greift die Versorgungswechselspannung $U_N$ ab und wandelt sie in eine Versorgungskleinspannung $U_K$ um. Diese Versorgungskleinspannung $U_K$ stellt eine niedrige Gleichspannung dar, die beispielsweise in einem Wertebereich zwischen 3 V und 5 V liegen kann. Die Versorgungseinheit 19 umfasst dabei einen Gleichrichter sowie einen Pufferkondensator, an welchem die Versorgungskleinspannung $U_K$ anliegt. Die Versorgungseinheit 19 stellt also ein kleines transformatorloses Netzteil dar. Die Versorgungswechselspannung $U_N$ wird somit kapazitiv ausgekoppelt, gleichgerichtet und als Versorgungskleinspannung $U_K$ in dem Pufferkondensator gespeichert.

Mit der Versorgungseinheit 19 ist eine Auswerteeinheit 20 gekoppelt, die mit der Versorgungskleinspannung $U_K$ versorgt wird. Die Auswerteeinheit 20 ist mit einem Berührungs- oder Annäherungssensor 21 gekoppelt, welcher eine Sensorelektrode 22 aufweist. Nähert sich eine Bedienperson der Sensorelektrode 22, so ändert sich die Kapazität eines diese Elektrode 22 aufweisenden Kondensators. Diese Änderung der Kapazität wird dann unmittelbar durch die Auswerteeinheit 20 erfasst, nämlich anhand der Änderung eines Zustandsänderungssignals $U_Z$ - sei es in der Amplitude oder Frequenz.

Vorliegend geht es um das Umschalten des Haushaltsgeräts zwischen einem Aktivzustand, in welchem das Netzteil 7 mit dem Schaltungseingang 2 gekoppelt ist und die Betriebsspannung $U_B$ bereitstellt, und einem gegenüber dem Aktivzustand energieverbrauchsreduzierten Wartezustand, in welchem das Netzteil 7 vom Schaltungseingang 2 entkoppelt ist. Zu diesem Zwecke umfasst die Schaltungsanordnung 1 einen Schaltkreis 23, welcher sowohl mit der Auswerteeinheit 20 als auch mit der Steuereinrichtung 17 gekoppelt ist. Über den Schaltkreis 23 können die Auswerteeinheit 20 und die Steuereinrichtung 17 die Schalteinheit 8 schalten, nämlich unter Ausgabe entsprechender Stromimpulse. Die elektrischen Schalter 9, 10 sind zum Beispiel bistabile Relais, die durch ein Beaufschlagen mit einem Stromimpuls in den jeweiligen mechanisch stabilen Schaltzustand überführt werden können. Sie können aber auch einfache Relais sein. Der Schaltkreis 23 wird dabei mit der Versorgungskleinspannung $U_K$ von der Versorgungseinheit 19 oder, wenn das Netzteil 7 eingeschaltet ist, mit der Betriebsspannung $U_B$ von dem Netzteil 7 versorgt. Dies ist durch eine Verbindung des Schaltkreises 23 einerseits mit der Versorgungseinheit 19 und andererseits über eine Diode 24 mit dem Sekundärstromkreis 12 des Netzteils 7 ermöglicht. Diese Verbindung ist so konzipiert, dass die Versorgungseinheit 19 auch von dem Sekundärstromkreis 12 mit elektrischer Energie versorgt werden kann, nämlich über die Diode 24.

Ist die Schaltungsanordnung 1 im Betrieb, d.h. das Netzteil 7 mit dem Schaltungseingang 2 gekoppelt, so kann die Steuereinrichtung 17 das Haushaltsgerät in den Wartezustand überführen, indem sie die elektrischen Schalter 9, 10 öffnet. Dies erfolgt nach Erfülltsein eines vorbestimmten Kriteriums. Also überwacht die Steuereinrichtung 17, ob das vorbestimmte Kriterium erfüllt ist oder nicht. Erfolgt keine Eingabe durch eine Bedienperson über die Bedieneinrichtung 18 über ein vorbestimmtes Zeitintervall, so überführt die Steuereinrichtung 17 das Haushaltsgerät in den Wartezustand. Mit anderen Worten überwacht die Steuereinrichtung 17, ob Eingabesignale S von der Bedieneinrichtung 18 übermittelt werden oder nicht. Werden keine Eingabesignale S von der Bedieneinrichtung 18 über das vorbestimmte Zeitintervall gesendet, so wird das vorbestimmte Kriterium erfüllt und das Haushaltsgerät in den Wartezustand überführt. Es ist auch möglich, das Haushaltsgerät in den Wartezustand zu überführen, indem ein vorbestimmtes Eingabesignal S an die Steuereinrichtung 17 gesendet wird. Ein solches Eingabesignal S kann zum Beispiel durch Betätigen eines Tasters der Bedieneinrichtung 18 erzeugt werden. Das Haushaltsgerät wird auch dann in den Wartezustand überführt, wenn ein Prozess - zum Beispiel ein Wasch- oder Trocknungsprozess - gerade beendet wurde. Ist ein Prozess abgeschlossen, so überführt die Steuereinrichtung 17 das Haushaltsgerät in den Wartezustand, indem sie die Schalter 9, 10 öffnet.

Befindet sich das Haushaltsgerät im Wartezustand, so ist die Steuereinrichtung 17 ausgeschaltet. Dann kann lediglich die Auswerteeinheit 20 die elektrischen Schalter 9, 10 wieder schließen und so das Haushaltsgerät in den Aktivzustand überführen. Dies erfolgt nach einem Berühren des Berührungs- oder Annäherungssensors 21 oder bei einer Annäherung einer Bedienperson an selbigen Sensor 21.

Die Auswerteeinheit 20 kann - wenn die Schalter 9, 10 keine bistabilen Schalter sind - nach Wiederkehr einer vorher ausgefallenen Versorgungswechselspannung $U_N$ unmittelbar die elektrischen Schalter 9, 10 schließen. Die Steuereinrichtung 17, die somit unmittelbar mit elektrischer Energie versorgt wird, kann dann entweder den geschlossenen Schaltzustand der Schalter 9, 10 aufrechterhalten oder selbige Schalter 9, 10 öffnen. Und zwar verbleiben die Schalter 9, 10 dann im geschlossenen Schaltzustand, wenn durch den Ausfall der Versorgungswechselspannung $U_N$ ein zuvor begonnenes Programm des Haushaltsgeräts unterbrochen wurde. Dann kann das Programm ordnungsgemäß abgeschlossen werden. Die Schalter 9, 10 werden hingegen dann durch die Steuereinrichtung 17 geöffnet, wenn vor dem Ausfall der Versorgungswechselspannung $U_N$ kein Programm des Haushaltsgerät aktiv war. Dann wird die Steuereinrichtung 17 ausgeschaltet, und das Haushaltsgerät geht wieder in den Wartezustand über.

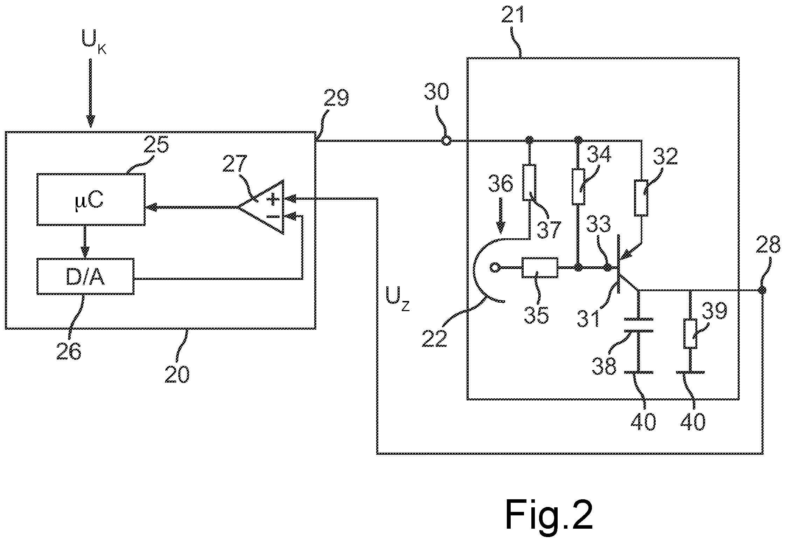

Eine mögliche Vorgehensweise bei der Auswertung des Zustandsänderungssignals $U_Z$ wird nachfolgend unter Bezugnahme auf Fig. 2 näher beschrieben.

Fig. 2 zeigt in schematischer Darstellung die Auswerteeinheit 20 und den Berührungs- oder Annäherungssensor 21. Die Auswerteeinheit 20 umfasst einen Mikrocontroller 25, einen Digital-Analog-Wandler 26 und einen analogen Komparator 27. Der negative Eingang des Komparators 27 ist mit einem Ausgang des Digital-Analog-Wandlers 26 gekoppelt, und der positive Eingang des Komparators 27 ist mit einem Ausgang 28 des Berührungs- oder Annäherungssensors 21 gekoppelt. Über einen Ausgang 29 kann die Auswerteeinheit 20 den Berührungs- oder Annäherungssensor mit Spannungsimpulsen beaufschlagen, nämlich aus der Versorgungskleinspannung $U_K$, hierzu ist der Ausgang 29 mit einem Eingang 30 des Berührungs- oder Annäherungssensors 21 verbunden. An den positiven Eingang des Komparators 27 wird das Zustandsänderungssignal $U_Z$ übermittelt.

Der kapazitive Berührungs- oder Annäherungssensor 21 umfasst einen PNP-Bipolartransistor 31, dessen Emitter über einen ohmschen Widerstand 32 mit dem Eingang 30 gekoppelt ist. Ein Steueranschluss 33 des Bipolartransistors 31 ist über einen ohmschen Widerstand 34 mit dem Eingang 30 sowie über einen ohmschen Widerstand 35 mit einem Kondensator 36 gekoppelt. Die Sensorelektrode 22 des Kondensators 36 ist über einen ohmschen Widerstand 37 mit dem Eingang 30 gekoppelt. Der Kollektor des Bipolartransistors 31 ist mit dem Ausgang 28 verbunden, wie auch über eine Parallelschaltung aus einem Kondensator 38 und einem ohmschen Widerstand 39 mit einem Bezugspotenzial 40 gekoppelt. Der Kapazitätswert des Kondensators 38 beträgt im Ausführungsbeispiel 1 nF, dieser Kapazitätswert kann jedoch in einem Wertebereich von 500 pF bis 50 nF, noch bevorzugter in einem Wertebereich von 800 pF bis 10 nF liegen. Also ist der Kapazitätswert des Kondensators 38 relativ gering.

Die Funktionsweise des kapazitiven Berührungs- oder Annäherungssensors 21 wird nachfolgend näher erläutert. Wird der kapazitive Berührungs- oder Annäherungssensor 21 - über den Eingang 30 - mit einer Abfolge von Spannungsimpulsen beaufschlagt, so erzeugt der Berührungs- oder Annäherungssensor 21 am Ausgang 28 ebenfalls Spannungsimpulse. Die Amplitude dieser Spannungsimpulse ist dann abhängig von der Kapazität des Kondensators 36. Dabei stellt die Sensorelektrode 22 ein Bedienelement dar: Durch Annäherung eines Gegenstands, der ein von dem Bezugspotential 40 unterschiedliches Potential, insbesondere das Potential der Erde führt, wird die Kapazität des Kondensators 36 verändert. Also kann eine Bedienperson einen Finger an die Sensorelektrode 22 annähern, um die Kapazität des Kondensators 36 zu verändern und somit die Amplitude der vom Berührungs- oder Annäherungssensor 21 ausgegebenen Spannungsimpulse zu verändern. Es gilt dabei die Beziehung, dass die Amplitude der am Ausgang 28 ausgegebenen Spannungsimpulse höher ist, wenn eine Bedienperson den Berührungs- oder Annäherungssensor 21 betätigt beziehungsweise wenn sich der Finger in der Umgebung der Sensorelektrode 22 befindet.

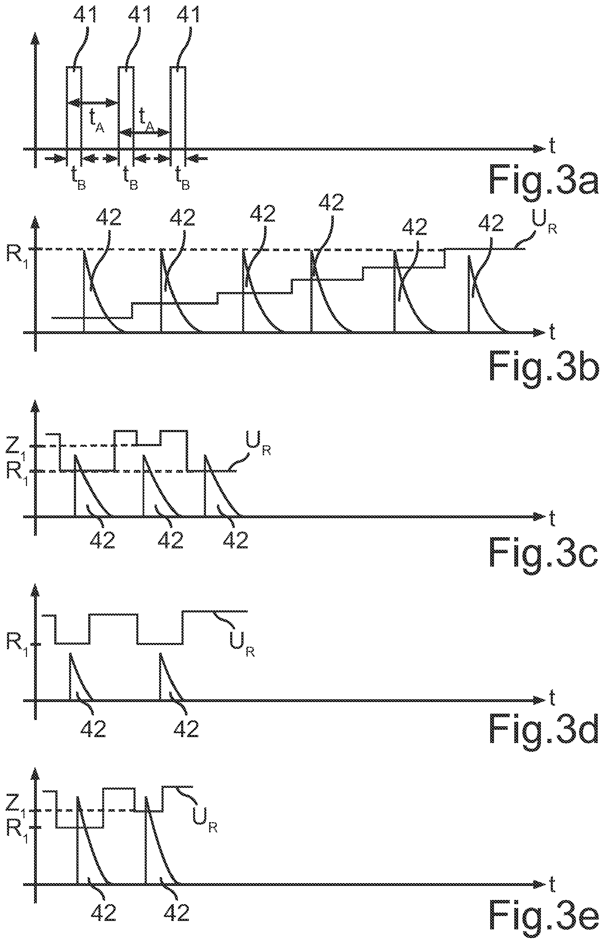

Um zu überprüfen, ob eine Bedienperson den Berührungs- oder Annäherungssensor 21 betätigt oder nicht, beaufschlagt der Mikrocontroller 25 den Berührungs- oder Annäherungssensor 21 in vorbestimmten Zeitabständen jeweils mit einer vorbestimmten Anzahl von Spannungsimpulsen, z.B. mit zwei, drei oder vier Spannungsimpulsen. Eine solche Abfolge von an den Berührungs- oder Annäherungssensor 21 abgegebenen Spannungsimpulsen 41 ist in Fig. 3a dargestellt. Auf der x-Achse ist die Zeit t aufgetragen. Die Amplitude der Spannungsimpulse 41 ist gleich der Amplitude der Versorgungskleinspannung $U_k$. Zum Beispiel werden hier drei Spannungsimpulse 41 an den Berührungs- oder Annäherungssensor 21 abgegeben. Die Pulsbreite $t_B$ beträgt im Ausführungsbeispiel z.B. 20 $\mu$s. Die Pulsbreite $t_B$ kann in einem Wertebereich von 10 $\mu$s bis 50 $\mu$s liegen. Der zeitliche Abstand $t_A$ zwischen zwei nacheinander folgenden Spannungsimpulsen 41 beträgt im Ausführungsbeispiel 60 $\mu$s. Der zeitliche Abstand $t_A$ kann in einem Wertebereich von 60 $\mu$s bis 100 $\mu$s liegen. Solche Abfolge von drei Spannungsimpulsen 41 wird an den Berührungs- oder Annäherungssensor 21 abgegeben. Entsprechend gibt der Berührungs- oder Annäherungssensor 21 Spannungsimpulse aus, die durch die Auswerteeinheit 20 ausgewertet werden.

Die vom Berührungs- oder Annäherungssensor 21 ausgegebenen Spannungsimpulse werden an den positiven Eingang des Komparators 27 geführt. An dem negativen Eingang liegt ein Referenzsignal $U_R$ an, das von dem Mikrocontroller 25 erzeugt wird. Ist die Amplitude der vom Berührungs- oder Annäherungssensor 21 ausgegebenen Spannungsimpulse (Zustandsänderungssignal $U_Z$) größer als die Amplitude des Referenzsignals $U_R$, so gibt der Komparator 27 eine logische "Eins" aus. Ist die Amplitude des Spannungsimpulses kleiner als die Amplitude des Referenzsignals $U_R$, so gibt der Komparator 27 eine logische "Null" aus.

Die Auswertung der vom Berührungs- oder Annäherungssensor 21 ausgegebenen Spannungsimpulse wird nachfolgend näher beschrieben. Zuerst - d.h. unmittelbar nach dem Koppeln des Schaltungseingangs 2 mit dem elektrischen Versorgungsnetz - erfolgt eine Kalibrierung des Referenzsignals $U_R$. Der Ablauf dieser Kalibrierung ist in Fig.

3b gezeigt. Der Mikrocontroller 25 beaufschlagt den Berührungs- oder Annäherungssensor 21 mit einer Abfolge von Spannungsimpulsen. Der Berührungs- oder Annäherungssensor 21 gibt entsprechend eine Abfolge von Spannungsimpulsen 42 gemäß Fig. 3b aus. Der Mikrocontroller 25 erhöht stufenweise die Amplitude des Referenzsignals $U_R$, bis diese Amplitude die Amplitude der Spannungsimpulse 42 überschreitet. Nach Abschluss der Kalibrierung legt der Mikrocontroller 25 einen ersten Referenzwert $R_1$ des Referenzsignals $U_R$ fest. Dieser erste Referenzwert $R_1$ wird zu Beginn des Betriebs der Schaltungsanordnung 1 als Referenz für die Spannungsimpulse 42 verwendet. Und zwar wird abhängig von dem ersten Referenzwert $R_1$ ein Wertebereich bestimmt, dessen unterer Grenzwert gleich dem ersten Referenzwert $R_1$ ist. Der obere Grenzwert kann bezüglich des unteren Grenzwerts vordefiniert werden. Also wird zu Beginn des Betriebes der Schaltungsanordnung 1 ein Wertebereich von $R_1$ bis $Z_1$ bestimmt.

Wie bereits ausgeführt, überprüft der Mikrocontroller 25 alle 100 ms, ob eine Bedienperson den Berührungs- oder Annäherungssensor 21 betätigt oder nicht. Alle 100 ms beaufschlagt der Mirkocontroller 25 den Berührungs- oder Annäherungssensor 21 mit zum Beispiel drei Spannungsimpulsen 41. Diese Zeit muss jedoch nicht unbedingt 100 ms betragen; sie ist abhängig von den Anforderungen an die Bedienung sowie den Leistungsverbrauch im Wartezustand. Diese Zeit kann in einem Wertebereich von 5 ms bis 200 ms liegen. Der Mikrocontroller 25 überprüft dann, ob die Amplitude der vom Berührungs- oder Annäherungssensor 21 ausgegebenen Spannungsimpulse 42 innerhalb des bestimmten Wertebereichs von $R_1$ bis $Z_1$ liegt. Wird dies bestätigt, so wird das Haushaltsgerät in den Aktivzustand überführt.

Ein Beispiel für eine korrekte Betätigung ist in Fig. 3c dargestellt. Der Mikrocontroller 25 verändert die Amplitude des Referenzsignals $U_R$, nämlich zwischen dem unteren Grenzwert $R_1$ und dem oberen Grenzwert $Z_1$ des Wertebereichs. Aus Fig. 3c geht hervor, dass die Amplitude der Spannungsimpulse 42 innerhalb des Wertebereichs von $R_1$ bis $Z_1$ liegt. Der Mikrocontroller 25 erkennt also, dass eine Bedienperson den Berührungs- oder Annäherungssensor 21 betätigt, um die Schaltungsanordnung 1 in den Aktivzustand zu schalten.

In Fig. 3d ist der Fall gezeigt, in welchem keine Betätigung des Berührungs- oder Annäherungssensors 21 vorliegt. Die Amplitude der Spannungsimpulse 42 des Zustandsänderungssignals $U_Z$ ist nämlich geringer als der untere Grenzwert $R_1$ des Wertebereichs.

Ein Beispiel für eine nicht-korrekte Betätigung des Berührungs- oder Annäherungssensors 21 ist in Fig. 3e abgebildet. Wie aus Fig. 3e hervorgeht, liegt die Amplitude der Spannungsimpulse 42 oberhalb des oberen Grenzwerts $Z_1$ des Wertebereichs. Der Mikrocontroller 25 erkennt also, dass eine nicht-korrekte Betätigung des Berührungs- oder Annäherungssensors 21 vorliegt, und die Schaltungsanordnung 1 wird nicht in den Aktivzustand überführt.

Die Amplitude der vom Berührungs- oder Annäherungssensor 21 ausgegebenen Spannungsimpulse 42 hängt jedoch nicht nur von der Kapazität des Kondensators 36 (Fig. 2) ab, sondern auch von Umgebungsbedingungen, wie Temperatur und dergleichen. Um die Veränderung der Amplitude der Spannungsimpulse 42 durch etwaige Störgrößen zu berücksichtigen, wird der Wertebereich $R_1$ bis $Z_1$ mit der Zeit angepasst; der Wertebereich wird also stets verändert - somit werden die Grenzwerte nachfolgend allgemein als $R_x$ und $Z_x$ bezeichnet. Und zwar wird der untere Grenzwert $R_x$ abhängig von der Amplitude der empfangenen Spannungsimpulse 42 erneut bestimmt. Der obere Grenzwert $Z_x$ wird dann entsprechend angepasst.

Die Bestimmung des unteren Grenzwerts $R_x$ ergibt sich nach der Formel:

$$R_n = R_{n-1} + K^*(R_{n-1} - A_n),$$

wobei $R_n$ den aktuellen unteren Grenzwert des Wertebereichs, $R_{n-1}$ den vorangegangenen unteren Grenzwert des Wertebereichs, K einen Faktor kleiner eins und An die aktuelle Amplitude des empfangenen Spannungsimpulses 42 bezeichnen.

Es wird also eine Art gleitendes Mittel für den unteren Grenzwert $R_x$ berechnet, so dass etwaige Störgrößen bei der Auswertung der Spannungsimpulse 42 mitberücksichtigt werden, wie insbesondere die Temperatur.

Insgesamt wird also ein Haushaltsgerät mit einer Schaltungsanordnung 1 bereitgestellt, welches im Wartezustand sehr wenig Energie aufnimmt. Mit einem kapazitiven Berührungs- oder Annäherungssensor 21 mit zugehöriger Auswerteeinheit 20 hat sich herausgestellt, dass nur etwa 50 mW im Wartebetrieb verbraucht werden. Dies stellt eine Verbesserung gegenüber dem Aktivzustand dar, in welchem 2 W bis 20 W durch die Steuereinrichtung 17 verbraucht werden, wie auch gegenüber dem Stand der Technik, in welchem die Leistungsaufnahme zwischen 1 W und 3 W liegt.

**Bezugszeichenliste**

| 1 | Schaltungsanordnung |
|---|---|
| 2 | Schaltungseingang |

| | |
|---|---|
| 3, 4 | Eingangsanschlüsse |
| 5, 6 | Y-Kondensatoren |
| 7 | Netzteil |
| 8 | Schalteinheit |
| 9, 10 | elektrische Schalter |
| 11 | Primärstromkreis |
| 12 | Sekundärstromkreis |
| 13 | Transformator |
| 14, 15 | Wicklungen |
| 16 | Potentialbarriere |
| 17 | Steuereinrichtung |
| 18 | Bedieneinrichtung |
| 19 | Versorgungseinheit |
| 20 | Auswerteeinheit |
| 21 | Berührungs- /Annäherungssensor |
| 22 | Sensorelektrode |
| 23 | Schaltkreis |
| 24 | Diode |
| 25 | Mikrocontroller |
| 26 | Digital-Analog-Wandler |
| 27 | Komparator |
| 28, 29 | Ausgänge |
| 30 | Eingang |
| 31 | Bipolartransistor |
| 32, 34, 35, 37, 39 | Widerstände |
| 33 | Steueranschluss |
| 36, 38 | Kondensatoren |
| 40 | Bezugspotenzial |
| 41, 42 | Spannungsimpulse |
| 43 | Netzfilter |
| $R_1$ | unterer Grenzwert |
| S | Eingabesignale |
| $t_A$ | zeitlicher Abstand |
| $t_B$ | Pulsbreite |
| $U_B$ | Betriebsspannung |
| $U_K$ | Versorgungskleinspannung |
| $U_N$ | Versorgungswechselspannung |
| $U_R$ | Referenzsignal |
| $U_Z$ | Zustandsänderungssignal |
| $Z_1$ | oberer Grenzwert |

**Patentansprüche**

1. Haushaltsgerät mit einer Schaltungsanordnung (1) umfassend:

- einen Schaltungseingang (2) mit einem ersten und einem zweiten Eingangsanschluss (3, 4) zum Anlegen einer Versorgungswechselspannung ($U_N$),
- ein Netzteil (7) zum Bereitstellen einer Betriebsspannung ($U_B$), welches über einen elektrischen Schalter (9, 10) mit dem Schaltungseingang (2) koppelbar ist,
- eine Steuereinrichtung (17) zum Steuern des Haushaltsgeräts, welche mit der Betriebsspannung ($U_B$) versorgbar ist, und welche dazu ausgebildet ist, das Haushaltsgerät von einem Aktivzustand in einen Wartezustand durch Öffnen des elektrischen Schalters (9, 10) zu überführen,
- eine mit dem Schaltungseingang (2) gekoppelte Versorgungseinheit (19) zum Bereitstellen einer Versorgungskleinspannung ($U_K$), und
- eine Auswerteeinheit (20), die mit der Versorgungskleinspannung ($U_K$) versorgbar ist, und dazu ausgebildet ist, abhängig von einer Auswertung eines Zustandsänderungssignals ($U_Z$) das Haushaltsgerät von dem Wartezustand in den Aktivzustand durch Schließen des elektrischen Schalters (9, 10) zu überführen,

**dadurch gekennzeichnet, dass**
ein kapazitiver Berührungs- oder Annäherungssensor (21) mit der Auswerteeinheit (20) gekoppelt ist, der dazu ausgebildet ist, bei einem Berühren durch eine Bedienperson oder bei einer Annäherung der Bedienperson das Zustandsänderungssignal ($U_Z$) zu verändern,
wobei die Auswerteeinheit (20) zum Erfassen dieser Änderung ausgebildet ist und abhängig von der Änderung die Überführung von dem Wartezustand in den Aktivzustand durchführbar ist,
und wobei die Auswerteeinheit (20) dazu ausgelegt ist, in vorbestimmten Zeitabständen jeweils ein Beaufschlagen des Berührungs- oder Annäherungssensors (21) mit einer vorbestimmten Anzahl von Spannungsimpulsen (41) aus der Versorgungskleinspannung ($U_k$) zu veranlassen, um anhand von Spannungsimpulsen des Zustandsänderungssignals ($U_Z$) des Berührungs- oder Annäherungssensors (21) zu erkennen, ob eine Bedienperson den Berührungs- oder Annäherungssensor (21) betätigt.

2. Haushaltsgerät nach Anspruch 1, **dadurch gekennzeichnet, dass** der Berührungs- oder Annäherungssensor (21) umfasst:

   - einen Transistor (31), dessen Kollektor mit einem Ausgang (28) des Berührungs- oder Annäherungssensors (21) gekoppelt ist, und
   - einen Kondensator (36), dessen Kapazitätswert durch Annäherung veränderbar ist und der mit einem Steueranschluss (33) des Transistors (31) gekoppelt ist,

   wobei der Steueranschluss (33) und der Emitter des Transistors (31) mit einem Eingang (30) des Berührungs- oder Annäherungssensors (21) gekoppelt sind.

3. Haushaltsgerät nach Anspruch 1 oder 2, **dadurch gekennzeichnet, dass** die Zeitdauer ($t_B$) eines einzelnen Spannungsimpulses (41) in einem Wertebereich von 10 µs bis 50 µs liegt und/oder der zeitliche Abstand ($t_A$) zwischen zwei nacheinander folgenden Spannungsimpulsen (41) in einem Wertebereich von 60 µs bis 100 µs liegt.

4. Haushaltsgerät nach einem der Ansprüche 1 bis 3, **dadurch gekennzeichnet, dass** die Auswerteeinheit (20) dazu ausgebildet ist, das Zustandsänderungssignal ($U_Z$) mit einem Referenzsignal ($U_R$) zu vergleichen und abhängig von dem Vergleich zu erkennen, ob eine Bedienperson den Berührungs- oder Annäherungssensor (21) betätigt, wobei bevorzugt die Auswerteeinheit (20) dazu ausgelegt ist, durch Veränderung der Amplitude des Referenzsignals ($U_R$) die absolute Amplitude des Zustandsänderungssignals ($U_Z$) zu ermitteln.

5. Haushaltsgerät nach einem der Ansprüche 1 bis 4, **dadurch gekennzeichnet, dass** die Auswerteeinheit (20) dazu ausgelegt, eine Betätigung des Berührungs- oder Annäherungssensors (21) durch eine Bedienperson dann zu erkennen, wenn die Amplitude eines Spannungsimpulses (42) des Zustandsänderungssignals ($U_Z$) innerhalb eines bestimmten Wertebereichs ($R_x$ bis $Z_x$) liegt.

6. Haushaltsgerät nach Anspruch 5, **dadurch gekennzeichnet, dass** die Auswerteeinheit (20) dazu ausgelegt ist, nach Empfangen eines Spannungsimpulses (42) des Zustandsänderungssignals ($U_Z$) den Wertebereich ($R_x$ bis $Z_x$) für die Auswertung nachfolgender Spannungsimpulse (42) abhängig von der Amplitude des empfangenen Spannungsimpulses (42) erneut zu bestimmen.

7. Haushaltsgerät nach einem der vorhergehenden Ansprüche, **dadurch gekennzeichnet, dass** die Steuereinrichtung (17) dazu ausgelegt ist, den elektrischen Schalter (9, 10) nach Erfülltsein eines vorbestimmten Kriteriums zu öffnen und hierdurch das Haushaltsgerät von dem Aktivzustand in den Wartezustand zu überführen.

8. Haushaltsgerät nach Anspruch 7, **dadurch gekennzeichnet, dass** das vorbestimmte Kriterium umfasst, dass die Steuereinrichtung (17) über ein vorbestimmtes Zeitintervall keine Eingabesignale (S) von einer Bedieneinrichtung erhält.

9. Haushaltsgerät nach Anspruch 7, **dadurch gekennzeichnet, dass** das vorbestimmte Kriterium umfasst, dass die Steuereinrichtung (17) ein vorbestimmtes Eingabesignal (S) von einer Bedieneinrichtung erhält.

10. Haushaltsgerät nach Anspruch 7, **dadurch gekennzeichnet, dass** das vorbestimmte Kriterium umfasst, dass die Steuereinrichtung (17) einen Prozess des Haushaltsgeräts abgeschlossen hat.

11. Haushaltsgerät nach einem der vorhergehenden Ansprüche, **dadurch gekennzeichnet, dass** der elektrische Schalter (9, 10) ein bistabiler Schalter ist.

**12.** Haushaltsgerät nach einem der Ansprüche 1 bis 10, **dadurch gekennzeichnet, dass** die Auswerteeinheit (20) dazu ausgelegt ist, nach Wiederkehr einer ausgefallenen Versorgungswechselspannung ($U_N$) den elektrischen Schalter (9, 10) zu schließen und hierdurch das Haushaltsgerät von dem Wartezustand in den Aktivzustand zu überführen, wobei bevorzugt die Steuereinrichtung (17) dazu ausgelegt ist, abhängig von einer gespeicherten Information über ein mögliches, durch den Ausfall der Versorgungswechselspannung ($U_N$) unterbrochenes Programm des Haushaltsgeräts den elektrischen Schalter (9, 10) zu öffnen oder den geschlossenen Schaltzustand des Schalters (9, 10) aufrechtzuerhalten.

**13.** Verfahren zum Betreiben eines Haushaltsgeräts, mit den Schritten

- Anlegen einer Versorgungswechselspannung ($U_N$) an einen Schaltungseingang (2) einer Schaltungsanordnung (1),
- Bereitstellen einer Versorgungskleinspannung ($U_K$) durch eine mit dem Schaltungseingang (2) gekoppelte Versorgungseinheit (19), wobei mit der Versorgungskleinspannung ($U_K$) eine Auswerteeinheit (20) versorgt wird,
- Auswerten eines Zustandsänderungssignals ($U_Z$) durch die Auswerteeinheit (20),
- abhängig von der Auswertung Schließen eines elektrischen Schalters (9, 10) durch die Auswerteeinheit (20) und hierdurch Koppeln eines Netzteils (7) mit dem Schaltungseingang (2),
- Bereitstellen einer Betriebsspannung ($U_B$) für eine Steuereinrichtung (17) durch das Netzteil (7) und hierdurch Versetzen des Haushaltsgeräts aus einem Wartezustand in einen Aktivzustand,
- Überprüfen durch die Steuereinrichtung (17), ob ein vorbestimmtes Kriterium erfüllt ist,
- nach Erfülltsein des vorbestimmten Kriteriums Öffnen des elektrischen Schalters (9, 10) durch die Steuereinrichtung (17) und hierdurch Entkoppeln des Netzteils (7) von dem Schaltungseingang (2) und Versetzen des Haushaltsgeräts von dem Aktivzustand in den Wartezustand,

**dadurch gekennzeichnet, dass**
ein kapazitiver Berührungs- oder Annäherungssensor (21) mit der Auswerteeinheit (20) gekoppelt ist, der das Zustandsänderungssignal ($U_Z$) verändert, wenn eine Bedienperson den Berührungs- oder Annäherungssensor (21) berührt oder sich nähert,
wobei die Auswerteeinheit (20) diese Änderung erfasst und abhängig von dieser Änderung das Haushaltsgerät in den Aktivzustand überführt,
und wobei die Auswerteeinheit (20) in vorbestimmten Zeitabständen den Berührungs- oder Annäherungssensor (21) jeweils mit einer vorbestimmten Anzahl von Spannungsimpulsen (41) aus der Versorgungskleinspannung ($U_k$) beaufschlagt, um anhand von Spannungsimpulsen des Zustandsänderungssignals ($U_Z$) des Berührungs- oder Annäherungssensors (21) zu erkennen, ob eine Bedienperson den Berührungs- oder Annäherungssensor (21) betätigt.

**14.** Verfahren nach Anspruch 13, **dadurch gekennzeichnet, dass** das vorbestimmte Kriterium umfasst, dass über ein vorbestimmtes Zeitintervall keine Eingabesignale (S) von einer Bedieneinrichtung an die Steuereinrichtung (17) übertragen werden oder ein vorbestimmtes Eingabesignal (S) von einer Bedieneinrichtung an die Steuereinrichtung (17) übertragen wird oder die Steuereinrichtung (17) einen Prozess des Haushaltsgeräts abgeschlossen hat.

**Claims**

**1.** Domestic appliance having a circuit arrangement (1) comprising:

- a circuit input (2) having a first and a second input terminal (3, 4) for applying an AC supply voltage ($U_N$),
- a power supply unit (7) for providing an operating voltage ($U_B$), which can be coupled to the circuit input (2) via an electrical switch (9, 10),
- a control device (17) for controlling the domestic appliance, which control device (17) can be supplied with the operating voltage ($U_B$), and which is designed to transfer the domestic appliance from an active state to a wait state by opening the electrical switch (9, 10),
- a supply unit (19) coupled to the circuit input (2) for providing a low supply voltage ($U_K$), and
- an evaluation unit (20) which can be supplied with the low supply voltage ($U_K$), and is designed, as a function of an evaluation of a state change signal ($U_Z$), to transfer the domestic appliance from the wait state to the active state by closing the electrical switch (9, 10),

**characterised in that**
a capacitive touch or proximity sensor (21) is coupled to the evaluation unit (20), and is designed, when touched by an operator or when approached by the operator, to change the state change signal ($U_Z$),
wherein the evaluation unit (20) is designed to detect said change and, as a function of the change, the transfer from the wait state to the active state can be performed,
and wherein the evaluation unit (20) is designed, at predetermined time intervals in each case, to cause a predefined number of voltage pulses (41) from the low supply voltage ($U_K$) to be applied to the touch or proximity sensor (21), in order, on the basis of voltage pulses of the state change signal ($U_Z$) of the touch or proximity sensor (21), to detect whether an operator is actuating the touch or proximity sensor (21).

2. Domestic appliance according to claim 1, **characterised in that** the touch or proximity sensor (21) comprises:

    - a transistor (31) having a collector coupled to an output (28) of the touch or proximity sensor (21), and
    - a capacitor (36) whose capacitance value can be changed by approach, and which is coupled to a control terminal (33) of the transistor (31),

    wherein the control terminal (33) and the emitter of the transistor (31) are coupled to an input (30) of the touch or proximity sensor (21).

3. Domestic appliance according to claim 1 or 2, **characterised in that** the time period ($t_B$) of a single voltage pulse (41) lies in a range from 10 $\mu$s to 50 $\mu$s and/or the time interval ($t_A$) between two successive voltage pulses (41) lies in a range from 60 $\mu$s to 100 $\mu$s.

4. Domestic appliance according to one of claims 1 to 3, **characterised in that** the evaluation unit (20) is designed to compare the state change signal ($U_Z$) with a reference signal ($U_R$) and, as a function of the comparison, to detect whether an operator is actuating the touch or proximity sensor (21), wherein preferably the evaluation unit (20) is designed, by changing the amplitude of the reference signal ($U_R$), to determine the absolute amplitude of the state change signal ($U_Z$).

5. Domestic appliance according to one of claims 1 to 4, **characterised in that** the evaluation unit (20) is designed to detect an actuation of the touch or proximity sensor (21) by an operator when the amplitude of a voltage pulse (42) of the state change signal ($U_Z$) lies within a certain range ($R_x$ to $Z_x$).

6. Domestic appliance according to claim 5, **characterised in that** the evaluation unit (20) is designed, on receipt of a voltage pulse (42) from the state change signal ($U_Z$), again to ascertain the value range ($R_x$ to $Z_x$) for the evaluation of subsequent voltage pulses (42) as a function of the amplitude of the received voltage pulse (42).

7. Domestic appliance according to one of the preceding claims, **characterised in that** the control device (17) is designed to open the electrical switch (9, 10) on fulfilment of a predetermined criterion, and thereby to transfer the domestic appliance from the active state to the wait state.

8. Domestic appliance according to claim 7, **characterised in that** the predetermined criterion is that the control device (17) receives no input signals (S) from an operating device over a predetermined time interval.

9. Domestic appliance according to claim 7, **characterised in that** the predetermined criterion is that the control device (17) receives a predetermined input signal (S) from a control device.

10. Domestic appliance according to claim 7, **characterised in that** the predetermined criterion is that the control device (17) has completed a process of the domestic appliance.

11. Domestic appliance according to one of the preceding claims, **characterised in that** the electrical switch (9, 10) is a bistable switch.

12. Domestic appliance according to one of claims 1 to 10, **characterised in that** the evaluation unit (20) is designed, after restoration of a failed AC supply voltage ($U_N$), to close the electrical switch (9, 10) and thereby to transfer the domestic appliance from the wait state to the active state, wherein preferably the control device (17) is designed, as a function of stored information about a possible program of the domestic appliance interrupted by the failure of the AC supply voltage ($U_N$), to open the electrical switch (9, 10) or to maintain the closed state of the switch (9, 10).

13. Method of operating a domestic appliance, comprising the steps

- application of an AC supply voltage ($U_N$) to a circuit input (2) of a circuit arrangement (1),
- provision of a low supply voltage ($U_K$) by a supply unit (19) coupled to the circuit input (2), wherein an evaluation unit (20) is supplied with the low supply voltage ($U_K$),
- evaluation of a state change signal ($U_Z$) by the evaluation unit (20),
- as a function of the evaluation, closure of an electrical switch (9, 10) by the evaluation unit (20) and thereby coupling of a power supply unit (7) to the circuit input (2),
- provision of an operating voltage ($U_B$) for a control device (17) by the power supply unit (7), thereby moving the domestic appliance from a wait state to an active state,
- examination by the control device (17) of whether a predetermined criterion is fulfilled,
- on fulfilment of the predetermined criterion, opening of the electrical switch (9, 10) by the control device (17), thereby decoupling the power supply unit (7) from the circuit input (2) and moving the domestic appliance from the active state to the wait state,

**characterised in that**
a capacitive touch or proximity sensor (21) is coupled to the evaluation unit (20), and changes the state change signal ($U_Z$) when an operator touches or approaches the touch or proximity sensor (21),
wherein the evaluation unit (20) detects said change and, as a function of said change, transfers the domestic appliance into the active state,
and wherein the evaluation unit (20) is designed, at predetermined time intervals, to apply a predefined number of voltage pulses (41) from the low supply voltage ($U_K$) in each case to the touch or proximity sensor (21), in order, on the basis of voltage pulses of the state change signal ($U_Z$) of the touch or proximity sensor (21), to detect whether an operator is actuating the touch or proximity sensor (21).

14. Method according to claim 13, **characterised in that** the predetermined criterion is that, over a predetermined time interval, no input signals (S) are transmitted from an operating device to the control device (17) or a predetermined input signal (S) is transmitted from an operating device to the control device (17) or the control device (17) has completed a process of the domestic appliance.

## Revendications

1. Appareil ménager muni d'un agencement de circuit (1) comprenant :

- une entrée de circuit (2) comprenant une première et une deuxième bornes d'entrée (3, 4) destinées à appliquer une tension alternative d'alimentation ($U_N$),
- un bloc d'alimentation (7) destiné à fournir une tension de service ($U_B$), lequel peut être couplé à l'entrée de circuit (2) par l'intermédiaire d'un interrupteur électrique (9, 10),
- un organe de commande (17) destiné à commander l'appareil ménager, lequel dispositif de commande peut être alimenté avec la tension de service ($U_B$) et lequel est réalisé pour faire passer l'appareil ménager d'un état actif en un état d'attente par l'ouverture de l'interrupteur électrique (9, 10),
- une unité d'alimentation (19) couplée à l'entrée de circuit (2), destinée à fournir une basse tension d'alimentation ($U_K$), et
- une unité d'évaluation (20) qui peut être alimentée avec la basse tension d'alimentation ($U_K$) et qui est réalisée pour faire passer l'appareil ménager de l'état d'attente en l'état actif par la fermeture de l'interrupteur électrique (9, 10) en fonction d'une évaluation d'un signal de changement d'état ($U_Z$),

**caractérisé en ce qu'**
un capteur capacitif de contact ou de proximité (21) est couplé à l'unité d'évaluation (20), lequel est réalisé pour modifier le signal de changement d'état ($U_Z$) lors d'un contact par une personne de service ou lors d'un approchement de la personne de service,
l'unité d'évaluation (20) étant réalisée pour enregistrer ce changement, et le passage de l'état d'attente en l'état actif étant réalisable en fonction du changement,
et l'unité d'évaluation (20) étant conçue pour provoquer dans des intervalles de temps prédéterminés respectivement une application du capteur de contact ou de proximité (21) avec un nombre prédéterminé d'impulsions de tension (41) à partir de la basse tension d'alimentation ($U_K$) afin, à l'aide d'impulsions de tension du signal de changement d'état ($U_Z$) du capteur de contact ou de proximité (21), d'identifier si une personne de service actionne le capteur de contact ou de proximité (21).

2. Appareil ménager selon la revendication 1, **caractérisé en ce que** le capteur de contact ou de proximité (21) comprend :

- un transistor (31) dont le collecteur est couplé à une sortie (28) du capteur de contact ou de proximité (21), et
- un condensateur (36) dont la valeur de capacité est modifiable par approchement et qui est couplé à une borne de contrôle (33) du transistor (31),

la borne de contrôle (33) et l'émetteur du transistor (31) étant couplés à une entrée (30) du capteur de contact ou de proximité (21).

3. Appareil ménager selon la revendication 1 ou 2, **caractérisé en ce que** la durée ($t_B$) d'une seule impulsion de tension (41) est située dans une plage de valeurs de 10 $\mu$s à 50 $\mu$s et/ou **en ce que** l'intervalle temporel ($t_A$) entre deux impulsions de tension (41) se succédant l'une après l'autre est situé dans une plage de valeurs de 60 $\mu$s à 100 $\mu$s.

4. Appareil ménager selon l'une quelconque des revendications 1 à 3, **caractérisé en ce que** l'unité d'évaluation (20) est réalisée pour comparer le signal de changement d'état ($U_Z$) à un signal de référence ($U_R$) et, en fonction de la comparaison, pour identifier si une personne de commande actionne le capteur de contact ou de proximité (21), l'unité d'évaluation (20) étant de préférence conçue pour déterminer l'amplitude absolue du signal de changement d'état ($U_Z$) en raison de la modification de l'amplitude du signal de référence ($U_R$).

5. Appareil ménager selon l'une quelconque des revendications 1 à 4, **caractérisé en ce que** l'unité d'évaluation (20) est réalisée pour identifier un actionnement du capteur de contact ou de proximité (21) par une personne de service lorsque l'amplitude d'une impulsion de tension (42) du signal de changement d'état ($U_Z$) est située dans une plage de valeurs déterminée ($R_x$ à $Z_x$).

6. Appareil ménager selon la revendication 5, **caractérisé en ce que** l'unité d'évaluation (20) est conçue, après la réception d'une impulsion de tension (42) du signal de changement d'état ($U_Z$), pour déterminer de nouveau la plage de valeurs ($R_x$ à $Z_x$) pour l'évaluation d'impulsions de tension (42) suivantes en fonction de l'amplitude de l'impulsion de tension (42) reçue.

7. Appareil ménager selon l'une quelconque des revendications précédentes, **caractérisé en ce que** l'organe de commande (17) est conçu pour ouvrir l'interrupteur électrique (9, 10) une fois qu'un critère prédéterminé a été rempli et pour faire ainsi passer l'appareil ménager de l'état actif en l'état d'attente.

8. Appareil ménager selon la revendication 7, **caractérisé en ce que** le critère prédéterminé comprend le fait que l'organe de commande (17) ne reçoive aucun signal d'entrée (S) d'un dispositif de commande pendant un intervalle de temps prédéterminé.

9. Appareil ménager selon la revendication 7, **caractérisé en ce que** le critère prédéterminé comprend le fait que l'organe de commande (17) reçoive un signal d'entrée (S) prédéterminé d'un dispositif de commande.

10. Appareil ménager selon la revendication 7, **caractérisé en ce que** le critère prédéterminé comprend le fait que l'organe de commande (17) ait achevé un processus de l'appareil ménager.

11. Appareil ménager selon l'une quelconque des revendications précédentes, **caractérisé en ce que** l'interrupteur électrique (9, 10) est un interrupteur bistable.

12. Appareil ménager selon l'une quelconque des revendications 1 à 10, **caractérisé en ce que** l'unité d'évaluation (20) est conçue pour fermer l'interrupteur électrique (9, 10) une fois qu'une tension alternative d'alimentation ($U_N$) défaillante est revenue et pour faire ainsi passer l'appareil ménager de l'état d'attente en l'état actif, l'organe de commande (17), en fonction d'une information mémorisée concernant un programme possible de l'appareil ménager, interrompu en raison de la défaillance de la tension alternative d'alimentation ($U_N$), étant de préférence conçu pour ouvrir l'interrupteur électrique (9, 10) ou pour maintenir l'état de commutation fermé de l'interrupteur (9, 10).

13. Procédé de fonctionnement d'un appareil ménager, comportant les étapes

- application d'une tension alternative d'alimentation ($U_N$) à une entrée de circuit (2) d'un agencement de circuit (1),
- fourniture d'une basse tension d'alimentation ($U_K$) par une unité d'alimentation (19) couplée à l'entrée de circuit (2), une unité d'évaluation (20) étant alimentée avec la basse tension d'alimentation ($U_K$),
- évaluation d'un signal de changement d'état ($U_Z$) par l'unité d'évaluation (20),
- fermeture d'un interrupteur électrique (9, 10) par l'unité d'évaluation (20) en fonction de l'évaluation, et, par conséquent, couplage à l'entrée de circuit (2) d'un bloc d'alimentation (7),
- fourniture par le bloc d'alimentation (7) d'une tension de service ($U_B$) pour un organe de commande (17), et, par conséquent, mise de l'appareil ménager dans un état actif à partir d'un état d'attente,
- vérification par l'organe de commande (17) si un critère prédéterminé est rempli,
- ouverture de l'interrupteur électrique (9, 10) par l'organe de commande (17) une fois que le critère prédéterminé est rempli, et, par conséquent, découplage de l'entrée de circuit (2) du bloc d'alimentation (7) et mise de l'appareil ménager de l'état actif en l'état d'attente,

**caractérisé en ce qu'**
un capteur capacitif de contact ou de proximité (21) est couplé à l'unité d'évaluation (20), lequel modifie le signal de changement d'état ($U_Z$) lorsqu'une personne de service touche ou s'approche du capteur de contact ou de proximité (21),

l'unité d'évaluation (20) enregistrant ce changement et, en fonction de ce changement, faisant passer l'appareil ménager à l'état actif,

et l'unité d'évaluation (20) appliquant au capteur de contact ou de proximité (21) à intervalles de temps prédéterminés, respectivement un nombre prédéterminé d'impulsions de tension (41) à partir de la basse tension d'alimentation ($U_K$) afin, à l'aide d'impulsions de tension du signal de changement d'état ($U_Z$) du capteur de contact ou de proximité (21), d'identifier si une personne de service actionne le capteur de contact ou de proximité (21).

14. Procédé selon la revendication 13, **caractérisé en ce que** le critère prédéterminé comprend le fait qu'aucun signal d'entrée (S) ne soit transmis à l'organe de commande (17) par un dispositif de commande pendant un intervalle de temps prédéterminé ou qu'un signal d'entrée (S) prédéterminé soit transmis à l'organe de commande (17) par un dispositif de commande ou que l'organe de commande (17) ait achevé un processus de l'appareil ménager.

Fig.1

Fig.2

Fig.3a

Fig.3b

Fig.3c

Fig.3d

Fig.3e

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- GB 2341500 A
- DE 202006019991 U1
- EP 1675265 A2
- EP 0746100 A1
- US 5194951 A
- EP 0689351 A2
- DE 102005041113 A1